# EUROPEAN PATENT SPECIFICATION

(11) **EP 1 887 842 B1**
(45) Date of publication and mention of the grant of the patent: **11.11.2009**
(21) Application number: 06025707.8
(22) Date of filing: 12.12.2006
(51) Int. Cl.: H05K 1/02, H05K 5/00, H05K 5/04, H05K 7/20, B60R 16/023, H05K 5/06

(54) **Case for housing electronic unit**
Gehäuse zur Aufnahme einer elektronischen Einheit
Boîtier pour unité électronique

(30) Priority: 01.08.2006 JP 2006210286
(43) Date of publication of application: 13.02.2008
(73) Proprietor: DENSO CORPORATION, Kariya-city, Aichi-pref. 448-8661 (JP)
(72) Inventor: Shinoda, Takuya, Kariya-city, Aichi-pref., 448-8661 (JP); Fukaya, Yuuichirou, Kariya-city, Aichi-pref., 448-8661 (JP); Mizutani, Akihiro, Kariya-city, Aichi-pref., 448-8661 (JP); Umemoto, Satoru, Kariya-city, Aichi-pref., 448-8661 (JP); Iida, Taku, Kariya-city, Aichi-pref., 448-8661 (JP); Yamauchi, Satoshi, Kariya-city, Aichi-pref., 448-8661 (JP); Katoh, Keiichi, Kariya-city, Aichi-pref., 448-8661 (JP)
(74) Representative: Winter, Brandl, Fürniss, Hübner Röss, Kaiser, Polte Partnerschaft Patent- und Rechtsanwaltskanzlei

(56) References cited:
- EP-A- 1 250 034
- EP-A- 1 806 960
- JP-A- 2002 246 762
- US-A- 5 872 332
- US-B1- 6 552 911

## Description

The present invention relates to a case for housing an electronic unit.

JP-A-2002-246762, which forms the basis for the preamble of claim 1, discloses a case for housing electronic components, and the case includes a cover member and a base member. The cover member has an aperture on its base part, and the aperture is closed with the base member. The base member has an approximately flat shape. A circuit substrate integrated with a connector is inserted between the cover member and the base member. The cover member, the base member and the circuit substrate are assembled with screws in the inserted state.

A pair of mounting portions is integrally formed with the base member. The mounting portion is protruded to outside from the cover member, and is fitted to an object, e.g., vehicle. The mounting portion has a mounting hole, and a bracket is fitted to the mounting portion by using the mounting hole. The case constructed with the cover member and the base member is mounted to the object through the bracket fitted to the mounting portion. Alternatively, the mounting portion may be used as the bracket. In this case, the case is directly mounted to the object by using the mounting hole.

When the mounting portion is fitted to the object having a distortion, a stress may be generated in the mounting portion. Further, the stress may be transmitted to the circuit substrate, because the base member has a predetermined strength in order to reduce damages to the circuit substrate by an external force.

EP-A-1 806 960 is an intermediate document which additionally shows a stress-absorbing portion for absorbing such stress.

In view of the foregoing and other problems, it is an object of the present invention to provide a case for housing an electronic unit where a stress generated outside of the case can be restricted from being transmitted to a circuit substrate of the electronic unit in the case.

According to the present invention, this object is solved by a case for housing an electronic unit having the features of claim 1.

Accordingly, the stress can be restricted from being transmitted to the circuit substrate in the case, on which the electronic components are mounted.

The above and other objects, features and advantages of the present invention will become more apparent from the following detailed description made with reference to the accompanying drawings. In the drawings:
FIG. 1 is a disassembled perspective view showing a schematic construction of a case for housing an electronic unit having electronic components according to a first embodiment;
FIG. 2A is a plan view showing a circuit substrate mounted to a base member of the case, and FIG. 2B is a side view of FIG. 2A;
FIG. 3 is a cross-sectional view showing a part of the case;
FIG. 4 is a cross-sectional view showing a mounting portion of the base member;
FIG. 5 is a disassembled perspective view showing a schematic construction of a case for housing an electronic unit having electronic components according to a second embodiment;
FIG. 6 is a disassembled perspective view showing a schematic construction of a case for housing an electronic unit having electronic components according to a third embodiment;
FIG. 7 is a disassembled perspective view showing a schematic construction of a case for housing an electronic unit having electronic components according to a fourth embodiment;
FIG. 8A is a disassembled perspective view showing a schematic construction of a case for housing an electronic unit having electronic components according to a fifth embodiment, and FIG. 8B is an enlarged plan view showing a hole in a mounting portion;
FIG. 9 is an enlarged cross-sectional view showing a hole in a mounting portion according to a first modification of the fifth embodiment; and
FIG. 10 is an enlarged cross-sectional view showing a hole in a mounting portion according to a second modification of the fifth embodiment.

### (First Embodiment)

A case for housing an electronic unit including electronic components in a first embodiment has a waterproof structure, and is disposed outside of a vehicle compartment. For example, the case can be suitably used for housing an electric control unit (ECU) for an engine disposed in an engine compartment.

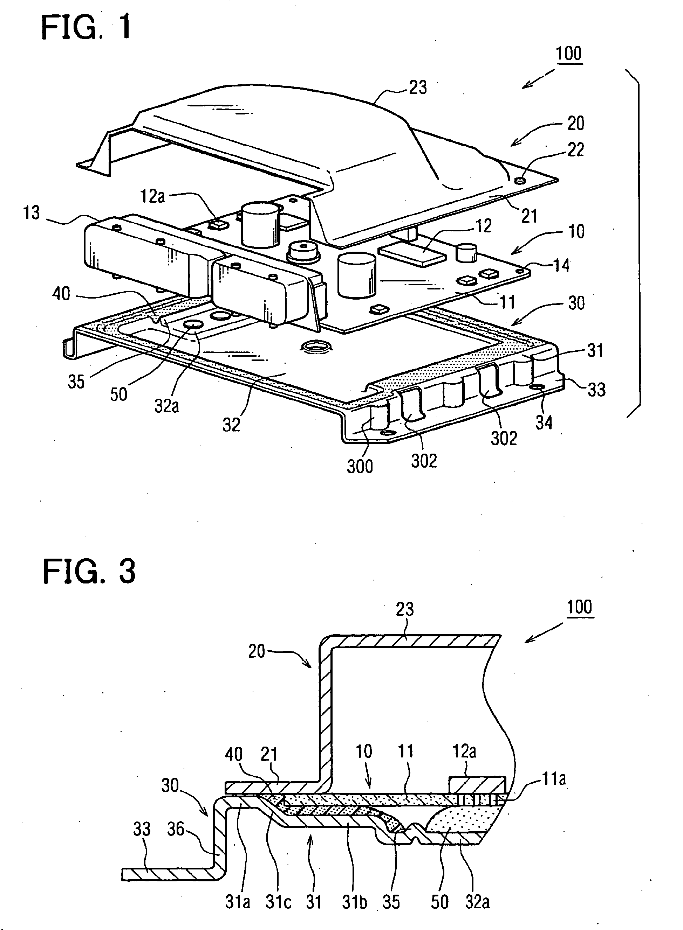

As shown in FIG. 1, an electronic device 100 includes a circuit substrate 10, a cover member 20, a base member 30, a sealing portion (agent) 40 and a heat conductor 50. The case is constructed with the cover member 20 and the base member 30. An inner space formed between the cover member 20 and the base member 30 accommodates the circuit substrate 10, and the inner space is waterproofed due to the sealing portion 40. The heat conductor 50 promotes a heat radiation from the circuit substrate 10.

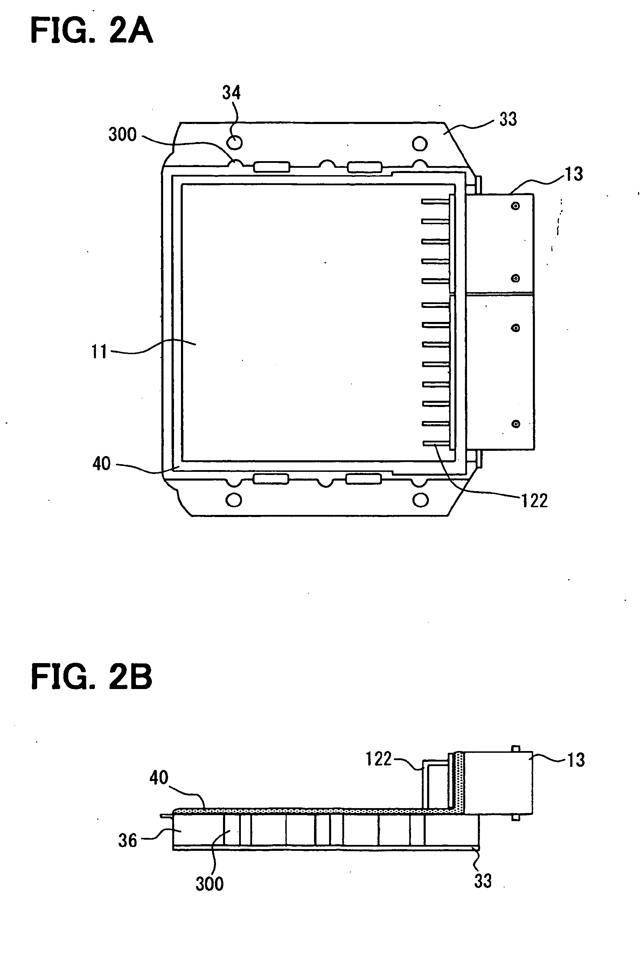

The circuit substrate 10 is constructed with a printed circuit board 11 and electronic components 12, e.g., microcomputers, resistors and capacitors, mounted to the printed circuit board 11. The electronic components 12 are omitted in FIGS. 2A and 2B. Wiring patterns (not shown) and via holes (not shown) for connecting the wiring patterns are formed on the printed circuit board 11. The printed circuit board 11 can be made of any material, e.g., thermoplastic resin, thermosetting resin, ceramic or glass-resin complex material. In the first embodiment, the printed circuit board 11 is formed of a multi-layered substrate, in which multi-layered wiring patterns are disposed on an epoxy resin including glass cloth.

A heating element 12a, e.g., power transistor, of the electronic components 12 excessively generates heat by its operation. As shown in FIGS. 1 and 3, the heating element 12a is positioned in periphery of the printed circuit board 11 in order to shorten a heat radiation path. A connector 13 is mounted to the printed circuit board 11 as an outside connection terminal, and includes terminals 122 shown in FIGS. 2A and 2B. The terminals 122 are electrically connected to the wiring patterns on the printed circuit board 11. A part of the connector 13 is exposed to an outside of the case, when the electronic device 100 is assembled. As shown in FIG. 1, a concave portion 14 is provided at a corner of the printed circuit board 11 in order to perform a positioning relative to the cover member 20. A thermal via hole 11a shown in FIG. 3 is formed in the printed circuit board 11 in order to promote a heat radiation from the heating element 12a to the base member 30.

The cover member 20 is formed into a deep box having an open end by pressing a copper board, for example. The cover member 20 has a fixing portion 21 facing the base member 30, and the fixing portion 21 is in contact with the sealing portion 40, as shown in FIG. 3. As shown in FIG. 1, a convex portion 22 corresponding to the concave portion 14 is disposed on the fixing portion 21 in order to perform a positioning. A space-forming portion 23 is formed by bending relative to the fixing portion 21, and forms therein an inner space.

The base member 30 is formed into a shallow box by pressing an aluminum board, for example, and closes the open end of the cover member 20. The aluminum board may have a thermal conductivity in a range between 150W/m·K and 230W/m·K. As described below, the base member 30 includes a stress-absorbing portion, i.e., a mounting portion 33 and/or a connection portion 36. The stress-absorbing portion absorbs a stress generated from a distortion (e.g., bump) of an object 200 (e.g., a side wall of the engine compartment) to be mounted. The base member 30 can easily absorb the stress, because the base member 30 is made of the aluminum board having the thermal conductivity equal to or larger than 150W/m.K. Therefore, the stress generated by the object 200 is difficult to be transmitted to the circuit substrate 10.

Further, the base member 30 radiates heat generated from the heating element 12a on the circuit substrate 10. A heat-transporting amount (W) of a material is equal to the product of the thermal conductivity (W/m·K) of the material, a temperature difference (K) and a conducting cross-section area (m²) divided by a distance (m). Therefore, the base member 30 can more easily radiate heat generated from the circuit substrate 10 to the object 200, because the base member 30 is made of the aluminum board having the large thermal conductivity.

For example, an aluminum die-cast material has a thermal conductivity of 90W/m·K, and steel has a thermal conductivity of 51W/m·K, which are generally used for forming the base member 30. However, by using aluminum having the thermal conductivity equal to or larger than 150W/m·K, heat radiation performance can be about double, compared with a case in which the aluminum die-cast material or steel is used.

Furthermore, when a pure aluminum having a thermal conductivity of 220-230W/m·K is used for forming the base member 30, the base member 30 becomes relatively soft. Then, the base member 30 can more easily absorb the stress generated from the distortion of the object 200, and the base member 30 can more easily radiate heat generated from the heating element 12a on the circuit substrate 10.

When the electronic device 100 is mounted to a vehicle, a predetermined heat radiation performance and a predetermined vibration-withstanding performance (resistance to vibration) may be required. In this case, by using an aluminum board having a thermal conductivity of 200W/m·K, the vibration-withstanding performance and the heat radiation performance can be improved. Thus, the heat radiation performance and the vibration-withstanding performance can be balanced.

The base member 30 includes a fixing portion 31, which is approximately in parallel to the fixing portion 21 of the cover member 20. The sealing portion 40 is disposed on at least a part of the fixing portion 31. As shown in FIG. 3, the fixing portion 31 is constructed with a narrow part 31a, a wide part 31b and a connection part 31c. In the narrow part 31a, a clearance between the fixing portion 21 of the cover member 20 and the fixing portion 31 of the base member 30 is narrow, or does not exist. That is, the sealing portion 40 may not be disposed in the clearance. In the wide part 31b, the clearance is wide, and the sealing portion 40 and the printed circuit board 11 are disposed in the clearance. The connection part 31c is bent, and connects the narrow part 31a and the wide part 31b.

A space-forming portion 32 of the base member 30 is formed by bending relative to the fixing portion 31, and forms an inner space. As shown in FIG. 3, an elevated area 32a is provided in a part of the space-forming portion 32, corresponding to an area for the heating element 12a. When the electronic device 100 is assembled, as shown in FIG. 1, a clearance between the elevated area 32a and the printed circuit board 11 is narrower than a clearance between the other part of the space-forming portion 32 and the printed circuit board 11. In contrast, the clearance between the elevated area 32a and the printed circuit board 11 is wider than a clearance between the wide part 31b and the printed circuit board 11, as shown in FIG. 3. The heat conductor 50 is disposed on the elevated area 32a. Thus, the heat radiation performance can be improved.

The base member 30 includes a mounting portion 33, which is fixed to the object 200. The mounting portion 33 has a through hole 34 for screwing. A connection portion 36 is bent in approximately perpendicular to the fixing portion 31 toward a direction opposite to the cover member 20. The mounting portion 33 is bent in approximately perpendicular to the connection portion 36 toward a direction opposite to the space-forming portion 32, that is, an outside direction from the base member 30. The mounting portion 33 is a bracket to be fitted to the object 200, and formed through the connection portion 36 having a leg shape. As shown in FIG. 3, a heat radiation path is formed such that heat generated in the circuit substrate 10 is transmitted to the object 200 through the heat conductor 50 and the base member 30. Thus, because the heating element 12a is positioned in periphery of the printed circuit board 11, the heat radiation path can be shortened and the heat radiation performance can be improved. Further, the connection portion 36 having the leg shape can absorb the stress from the object 200. Thus, the stress transmitted from the object 200 to the circuit substrate 10 can be effectively reduced.

The connection portion 36 constructs the stress-absorbing portion, and is formed by pressing the aluminum board at the forming time of the base member 30. A hardness of the connection portion 36 is sufficiently lower than that of the circuit substrate 10, i.e., the printed circuit board 11. A stress generated in the object 200 is easily transmitted to the circuit substrate 10 through the mounting portion 33 and the connection portion 36, if the base member 30 is made of an aluminum die-cast material or steel, which has a larger hardness than aluminum. Because the hardness of the connection portion 36 is sufficiently low, a crack in a connection part of the electronic components 12, the connector 13 and the printed circuit board 11 can be reduced.

Further, as shown in FIG. 1, a slit 302 is formed in the connection portion 36 in a direction connecting the fixing portion 31 and the mounting portion 33. Even if the connection portion 36 is distorted by a stress, the stress can be absorbed by the slit 302, thereby preventing a crack in the connection portion 36.

In addition, the hardness of the connection portion 36 is sufficiently low. Even if a stress is generated in the connection portion 36 by the distortion of the object 200, the stress can be absorbed by a deformation of the connection portion 36. Therefore, the stress can be restricted from being transmitted to the circuit substrate 10.

When the case is vibrated, the connection portion 36 may be damaged by a resonance due to a weight of the circuit substrate 10 and the cover member 20, because the connection portion 36 is made of the aluminum board. Therefore, as shown in FIG. 1, strengthening ribs 300 are formed in the connection portion 36 in a direction connecting the fixing portion 31 and the mounting portion 33. Thus, the damage of the connection portion 36 can be restricted, because the vibration-withstanding performance can be improved. The strengthening ribs 300 may be integrally formed with the base member 30 at the pressing time of the base member 30, or may be additionally fitted to the connection portion 36. In the first embodiment, three ribs 300 are provided in the connection portion 36. However, the number of the ribs 300 is not limited to this, as long as the connection portion 36 can absorb the stress and reduce the damage.

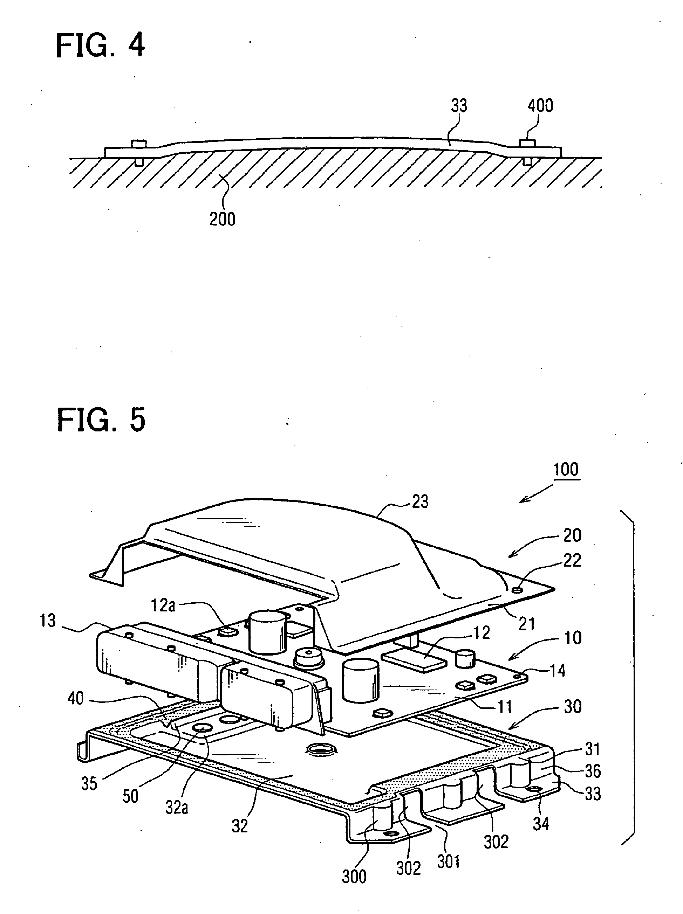

The mounting portion 33 constructs the stress-absorbing portion, and is formed by pressing the aluminum board at the forming time of the base member 30. A hardness of the mounting portion 33 is sufficiently lower than that of the circuit substrate 10, i.e., printed circuit board 11. Even if a stress is generated in the mounting portion 33 by the distortion of the object 200, the stress can be absorbed by a deformation of the mounting portion 33. That is, as shown in FIG. 4, even if the mounting portion 33 is fixed to the object 200 having the distortion by using screws 400, because the mounting portion 33 itself can be plastically deformed to conform to the distortion, the mounting portion 33 is not spaced from the object 200. Therefore, the stress can be restricted from being transmitted to the circuit substrate 10. Further, the mounting portion 33 can have a larger contact area with the object 200 by the plastic transformation. Thus, heat generated from the heating element 12a on the circuit substrate 10 can be easily transmitted to the object 200. In addition, in order to plastically deform the mounting portion 33 at the screwing time, the aluminum board used for forming the base member 30, i.e., mounting portion 33, has yield strength at 0.2 % (proof stress at 0.2%) equal to or lower than 100N/mm². The yield strength at 0.2% is a stress generating a plastic deformation of 0.2% of an unstressed length.

When the stress-absorbing portion, i.e., the mounting portion 33 and/or the connection portion 36, is made of a material whose hardness is lower than that of the circuit substrate 10, the stress generated by the object 200 can be easily absorbed by the stress-absorbing portion. Thus, the stress is difficult to be transmitted to the circuit substrate 10.

When the mounting portion 33 is made of a plastically deformable material, the mounting portion 33 can absorb the distortion of the object 200. Thus, the stress is difficult to be transmitted to the circuit substrate 10.

When at least one of the connection portion 36 and the mounting portion 33 absorbs the stress generated by the distortion of the object 200, the stress is difficult to be transmitted to the circuit substrate 10.

The base member 30 includes a protruding portion 35 between the heat conductor 50 and the sealing portion 40, i.e., fixing portion 31. The protruding portion 35 protrudes inside of the base member 30, and is integrally formed with the base member 30 by pressing. Due to the protruding portion 35, the sealing portion 40 before hardened is restricted from flowing and contacting with the heat conductor 50, and the heat conductor 50 is restricted from moving and contacting with the sealing portion 40 by vibrations. Thus, the protruding portion 35 functions as a dam between the sealing portion 40 and the heat conductor 50.

Further, as shown in FIG. 3, a height of the protruding portion 35 is shorter than a dimension between the elevating area 32a and the printed circuit board 11 such that the protruding portion 35 is not in contact with the printed circuit board 11. Therefore, even if the base member 30 is made of a conductive material, the base member 30 and the printed circuit board 11 can be prevented from becoming a short circuit. Furthermore, the protruding portion 35 is disposed only in a close position between the heat conductor 50 and the fixing portion 30. Thus, a distortion can be restricted from being generated around the protruding portion 35, when the base member 30 is pressed. That is, a load due to the pressing can be reduced.

The sealing portion 40 has a repulsion force and an adhesive force, and is disposed between the cover member 20 and the base member 30. A space formed between the cover member 20 and the base member 30 can be waterproofed due to the sealing portion 40. In the first embodiment, moisture-curing type silicon adhesive having viscosity of 150-200 Pa·s before hardening is used as the sealing portion 40. Alternatively, a material described in JP-A-2005-93602 may be used as the sealing portion 40.

In order to transmit heat generated by the heating element 12a to outside through the base member 30, the heat conductor 50 is disposed between the base member 30 and the heating element 12a, or between the base member 30 and a back face of the printed circuit board 11, on which the heating element 12a is mounted. A heat conductor described in JP-A-2003-289191 is soft and pliable, that is, has a relatively low viscoelasticity. When this soft heat conductor is used as the heat conductor 50, adhesion performance can be improved. It is understood that heat radiation performance can be improved. Further, even if a clearance between the base member 30 and the printed circuit board 11, or a clearance between the base member 30 and the heating element 12a is not uniform, stress concentration on the heating element 12a can be reduced, because the heat conductor 50 is soft and pliable. Thus, damage of the heating element 12a can be restricted. In the first embodiment, a silicon gel having viscosity of 600-1000 Pa·s is used for the heat conductor 50, and the heat conductor 50 is disposed between the elevated area 32a of the base member 30 and a back face of the printed circuit board 11, on which the heating element 12a is mounted.

Next, an example method for assembling the electronic device 100 will be described. The circuit substrate 10, the cover member 20 and the base member 30 are prepared. The case, for housing the electronic unit including the circuit substrate 10 and the electronic components 12 on the substrate 10, is constructed with the cover member 20 and the base member 30. As shown in FIG. 1, the heat conductor 50 is disposed on the elevated area 32a, and the sealing portion 40 is coated on the fixing portion 31 of the base member 30. Then, as shown in FIG. 3, the circuit substrate 10 is disposed on the base member 30 through the sealing portion 40. More specifically, the circuit substrate 10 is disposed on the wide part 31b of the fixing portion 31. Thereafter, as shown in FIG. 2B, the sealing portion 40 is also coated on the connector 13 to be connected to the cover member 20. Then, the printed circuit board 11 and the cover member 20 are assembled such that the convex portion 22 of the cover member 20 is inserted into the concave portion 14 of the printed circuit board 11. Then, the cover member 20 is thrust on the base member 30 through the sealing portion 40.

At that time, as shown in FIG. 3, clearances formed among an edge of the printed circuit board 11, the fixing portion 21 of the cover member 20 and the fixing portion 31, i.e., connection part 31c, of the base member 30 are sealed by the sealing portion 40. Thus, sealing performance and reliability for connection can be secured. Because the circuit substrate 11 and the cover member 20 press the sealing portion 40, the sealing portion 40 may flow toward the elevated area 32a through a clearance between the wide part 31b and the printed circuit board 11. However, the sealing portion 40 and the heat conductor 50 are not in contact with each other due to the protruding portion 35, and the sealing portion 40 is hardened in this state. Each connection between the cover member 20 and the connector 13, the connector 13 and the base member 30, the base member 30 and the cover member 20, and the circuit substrate 10 and the base member 30 can be performed by the sealing portion 40. That is, a space formed by the connector 13, the cover member 20 and the base member 30 is made to a waterproof structure by the sealing portion 40, and accommodates the circuit substrate 10.

Further, the circuit substrate 10 and the base member 30 may be relatively strongly connected by fixing with a screw (not shown), after the circuit substrate 10 and the base member 30 are connected by the sealing portion 40. In this case, because the circuit substrate 10 is pressed to the base member 30, the heat conductor 50 is in close contact with the circuit substrate 10 and the base member 30. Because the heat conductor 50 functions as the heat radiation path, as described above, the heat radiation performance can be improved in the electronic device 100.

According to the electronic device 100 in the first embodiment, the case is constructed with the cover member 20 and the base member 30, which are respectively formed by pressing. Therefore, compared with a case in which the case is formed by metal mold casting, e.g., die-casting or resin injection molding, cost for manufacturing the case and weight of the case can be reduced. Even if only the base member 30 is formed by pressing, the manufacturing cost can be reduced.

Further, the stress generated by the object 200 is not transmitted to the circuit substrate 10, because the mounting portion 33 and/or the connection portion 36 absorb the stress. The cover member 20, the base member 30 and the connector 13 can be connected to each other through the sealing portion 40 without rigidly tightening screws. Thus, costs for parts and processes can be reduced by the elimination of the screws.

Further, clearances formed among an edge of the printed circuit board 11, the fixing portion 21 of the cover member 20 and the fixing portion 31, i.e., connection part 31c, of the base member 30 are sealed by the sealing portion 40. Thus, sealing performance and reliability for connection are secured, while the electronic device 100 is simply constructed. Because the sealing portion 40 is disposed between the printed circuit board 11 and the wide part 31b of the fixing portion 31, the reliability for connection can be more improved.

Further, because the sealing portion 40 extends in the wide part 31b, the sealing portion 40 can be made to have a long distance to the protruding portion 35. That is, when the cover member 20 is disposed on the base member 30, the sealing portion 40 extends along a space, i.e., passage, between the wide part 31b and the printed circuit board 11, because the sealing portion 40 is mobile and viscous. Therefore, the sealing performance, i.e., waterproof performance, can be improved, and the sealing portion 40 and the heat conductor 50 can be effectively restricted from contacting with each other.

Further, in order to shorten the heat radiation path, the elevated area 32a is provided in a part of the space-forming portion 32. The elevated area 32a corresponds to an area for the heating element 12a. When the electronic device 100 is assembled, a clearance between the elevated area 32a and the printed circuit board 11 is narrower than a clearance between the other space-forming portion 32 and the printed circuit board 11, as shown in FIG. 1. The heat conductor 50 is disposed on the elevated area 32a. However, the elevated area 32a may be eliminated.

Further, elements other than the electronic components 12 may be disposed on the printed circuit board 11. However, in order to promote the heat radiation, the heating element 12a may be positioned in periphery of the printed circuit board 11.

Further, the mounting portion 33 is fixed to the object 200 with the screws 400. Alternatively, the mounting portion 33 may be fixed to the object 200 by riveting or welding.

### (Second Embodiment)

In a second embodiment, a mount part slit 301 is provided in the mounting portion 33. The other parts may be made similar to the first embodiment.

As shown in FIG. 5, the base member 30 has the slit 301 in the mounting portion 33. The slit 301 extends from the connection portion 36 to an outer edge of the mounting portion 33. That is, the slit 301 is approximately perpendicular to the connection portion 36. Alternatively, the slit 301 may be formed in any direction connecting an outer edge of the mounting portion 33 and the connection portion 36.

Thus, a stress generated by the object 200 is difficult to be transmitted through the slit 301. Therefore, the stress becomes more difficult to be transmitted to the circuit substrate 10.

In the second embodiment, two of the slits 301 are formed in the mounting portion 33. However, the number of the slits 301 is not limited to this.

Furthermore, in the second embodiment, the slits 301 are provided to be continuously extended from the slits 302 formed in the connection portion 36, respectively. However, the slits 301 can be formed at different positions from the slits 302 to be partitioned from the slits 302 in the connection portion 36.

### (Third Embodiment)

In a third embodiment, a slit 302a is provided at an end of the connection portion 36 in a longitudinal direction of the connection portion 36. The other parts may be made similar to the above embodiments.

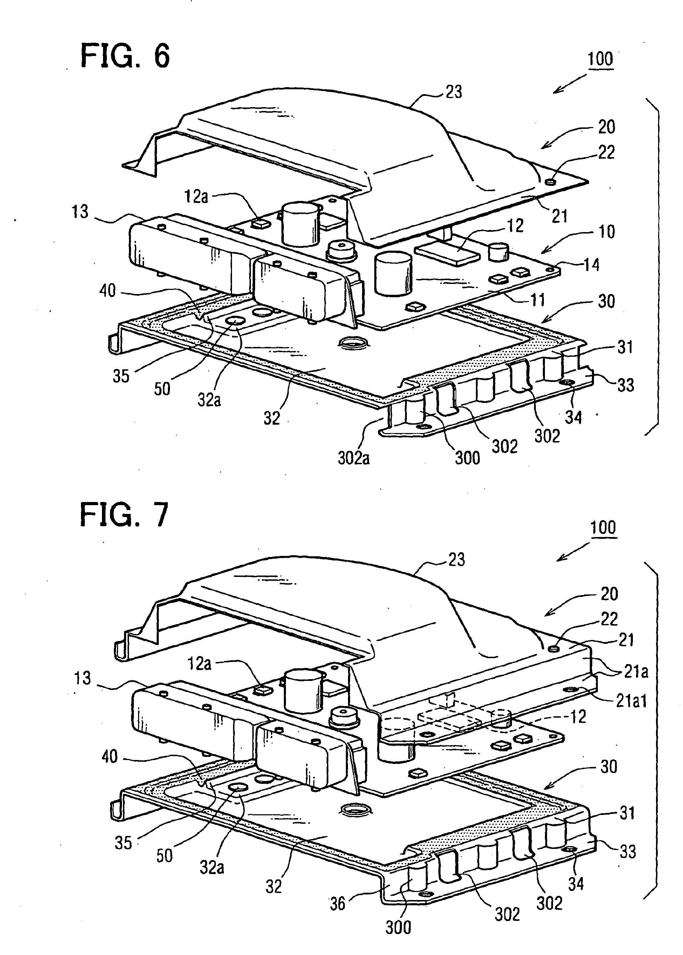

As shown in FIG. 6, the base member 30 has the slit 302a at the end of the connection portion 36, extending in a direction perpendicular to the longitudinal direction of the connection portion 36. That is, the slit 302a is approximately perpendicular to the fixing portion 31 and the mounting portion 33, and is formed therebetween.

Thus, stress twisting the connection portion 36 by the object 200 can be easily absorbed by the slit 302a at the end of the connection portion 36. Therefore, the stress generated by the object 200 becomes more difficult to be transmitted to the circuit substrate 10.

Cracks may be generated in the connection portion 36, when the connection portion 36 is distorted by the stress. Especially, the stress may be concentrated on the both ends of the connection portion 36. However, by arranging the slits 302a at the both ends of the connection portion 36, the stress can be more effectively absorbed. Therefore, the cracks can be reduced.

### (Fourth Embodiment)

In a fourth embodiment, the cover member 20 is fixed to the object 200 by screws. The other parts may be made similar to the above embodiments.

As shown in FIG. 7, the cover member 20 includes a mounting portion 21a having a screw hole 21a1 into which the screw is screwed, and the hole 21a1 is provided at a position corresponding to the hole 34 in the mounting portion 33 of the base member 30. The mounting portion 21a has a first part engaged with the connection portion 36 and a second part engaged with the mounting portion 33 of the base member 30. The first part of the mounting portion 21a is a connection portion, which is bent approximately perpendicular to the fixing portion 21 toward the base member 30. The second part of the mounting portion 21a is further bent approximately perpendicular to the connection portion toward an outside of the cover member 20. The cover member 20 and the base member 30 are together fixed to the object 200 with the screw.

Because the base member 30 is formed by pressing the aluminum board, the base member 30 is relatively weak to a tightening torque of the screw. However, because the cover member 20 and the base member 30 are together fixed to the object 200 with the screw, a tightening strength of the base member 30 can be improved against the tightening torque of the screw. In addition, in order to improve the tightening strength of the base member 30 against the tightening torque of the screw, the cover member 20 may have a hardness, which is equal to that of a copper board or an aluminum die-cast board.

### (Fifth Embodiment)

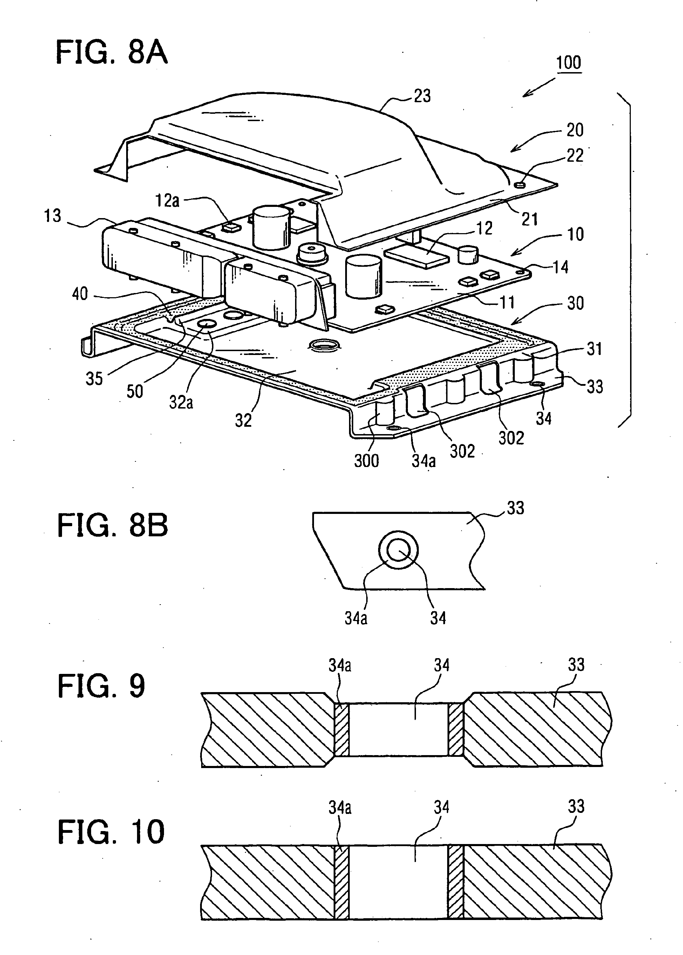

In a fifth embodiment, the hole 34 has a collar 34a shown in FIGS. 8A and 8B. The other parts may be made similar to the above embodiments.

Because the base member 30 is formed by pressing the aluminum board, the base member 30 is relatively weak to the tightening torque of the screw 400 (see FIG. 4). As shown in FIGS. 8A and 8B, the collar 34a is pressed into the hole 34 of the mounting portion 33. The collar 34a may be made of metal such as iron or aluminum die-cast product, e.g., ADC12. The collar 34a is pressed into the hole 34 at the pressing time of the base member 30.

Thus, the tightening strength of the base member 30 can be improved against the tightening torque of the screw 400. Further, when the collar 34a is made of iron, the manufacturing cost can be reduced. In contrast, when the collar 34a is made of the aluminum die-cast product, linear expansion coefficient of the collar 34a is equal to that of the mounting portion 33, because the mounting portion 33 is made of aluminum. Therefore, stress caused by repeating cooling and heating can be reduced.

As a first modification of the fifth embodiment, as shown in FIG. 9, the collar 34a may be pressed into the mounting portion 33 in a depression state. Thus, the collar 34a can be strongly fixed to the hole 34. Further, the collar 34a can be restricted from protruding from the mounting portion 33. Therefore, heat generated from the circuit substrate 10 can be more easily transmitted to the object 200, because a contact area between the mounting portion 33 and the object 200 is increased.

As a second modification of the fifth embodiment, as shown in FIG. 10, the collar 34a may be pressed into the mounting portion 33 such that an end face of the collar 34a is positioned on a face of the mounting portion 33. The face of the mounting portion 33 is to be in contact with the object 200. Even in this case, the collar 34a does not protrude from the mounting portion 33. Thus, heat generated from the circuit substrate 10 can be more easily transmitted to the object 200, because a contact area between the mounting portion 33 and the object 200 is increased.

### (Other Embodiments)

In the above-described embodiments, the slits 301, 302, 302a are provided for forming a stress-absorbing portion. However, as the stress-absorbing portion, the other shaped slits and holes may be provided instead of the slits 301, 302, 302a, and the shapes of the slits 301, 302, 302a may be suitably changed.

Such changes and modifications are to be understood as being within the scope of the present invention as defined by the appended claims.

## Claims

1. A case for housing an electronic unit including a circuit substrate (10) and electronic components (12) disposed on the circuit substrate (10), the case comprising
a base member (30) and a cover member (20), between which the circuit substrate (10) is disposed, wherein
the base member (30) includes:
a fixing portion (31), on which the circuit substrate (10) is fixed;
a base mounting portion (33) to be fitted to an object (200); and
a connection portion (36), between the fixing portion (31) and the mounting portion (33), for connecting the fixing portion (31) and the mounting portion (33), and **characterized in that**
at least one of the mounting portion (33) and the connection portion (36) has a stress-absorbing portion for absorbing a stress generated by the object (200), wherein the stress-absorbing portion has a hardness, which is lower than that of the circuit substrate (10).

2. The case according to claim 1, wherein:
the connection portion (36) is bent from the fixing portion (31) in approximately perpendicular to the fixing portion (31); and
the mounting portion (33) is bent from the connection portion (36) in approximately perpendicular to the connection portion (36).

3. The case according to any one of claims or 2, further comprising:
a strengthening rib (300) disposed on the connection portion (36) and extending in a direction connecting the fixing portion (31) and the mounting portion (33).

4. The case according to any one of claims 1-3, wherein:
the mounting portion (33) has a first slit (301) extending in a direction connecting an edge of the mounting portion (33) and the connection portion (36).

5. The case according to any one of claims 1-4, wherein:
the connection portion (36) has a second slit (302, 302a) extending in a direction connecting the fixing portion (31) and the mounting portion (33).

6. The case according to claim 5, wherein:
the second slit (302a) is provided at least at an end of the connection portion (36) in a longitudinal direction of the connection portion (36).

7. The case according to any one of claims 1-6, wherein:
the mounting portion (33) is made of a material, which is plastically deformable when the mounting portion (33) is fixed to the object (200) by a screw (400).

8. The case according to any one of claims 1-7, wherein:
the base member (30) is made of aluminum having a yield strength at 0.2% equal to or lower than 100N/mm².

9. The case according to any one of claims 1-8, wherein:
the base member (30) is made of a pressed aluminum board having a thermal conductivity equal to or larger than 150W/m·K.

10. The case according to any one of claims 1-9, wherein:
the mounting portion (33) has a base through hole (34) with a press-fitted collar (34a) into which a screw (400) is screwed.

11. The case according to claim 10, wherein:
the collar (34a) is made of metal.

12. The case according to claim 10 or 11, wherein:
the collar (34a) is made of an aluminum die-cast product.

13. The case according to any one of claims 10 to 12, wherein:
the collar (34a) is provided to be depressed from the mounting portion (33).

14. The case according to any one of claims 10 to 12, wherein:
the collar (34a) has at least one end face, which is positioned approximately on the same face as that of the mounting portion (33); and
the faces of the collar (34a) and the mounting portion (33) contact a face of the object (200).

15. The case according to any one of claims 10 to 14, wherein:
the cover member (20) includes a cover mounting portion (21 a) having a cover through hole (21a1) into which the screw (400) is screwed;
the cover through hole (21a1) of the cover mounting portion (21a) is provided at a position corresponding to the base through hole (34) in the base mounting portion (33); and
the cover member (20) and the base member (30) are together fixed to the object (200) by the screw (400) through the cover through hole (21a1) and the base through hole (34).

16. The case according to any one of claims 1-15, further comprising:
a sealing portion (40) disposed between the base member (30) and the circuit substrate (10).

17. The case according to any one of claims 1-16, further comprising:
a heat conductor (50) disposed between the base member (30) and the circuit substrate (10) so as to transmit heat generated in the circuit substrate (10) to outside through the base member (30).

18. The case according to claim 5, wherein:
the first slit (301) is provided to be continuously extended from the second slit (302) formed in the connection portion (36).

## Patentansprüche

1. Ein Gehäuse zur Aufnahme einer elektronischen Einheit, die ein Schaltkreissubstrat (10) und elektronische Komponenten (12) umfasst, die auf dem Schaltkreissubstrat (10) angeordnet sind, wobei das Gehäuse Folgendes aufweist:
ein Basisteil (30) und ein Abdeckteil (20), zwischen welchen das Schaltkreissubstrat (10) angeordnet ist, wobei
das Basisteil (30) Folgendes umfasst:
einen Befestigungsabschnitt (31), an welchem das Schaltkreissubstrat (10) befestigt ist;
einen Basismontageabschnitt (33), um an einem Objekt (200) montierbar zu sein; und
einen Verbindungsabschnitt (36) zwischen dem Befestigungsabschnitt (31) und dem Montageabschnitt (33), um den Befestigungsabschnitt (31) und den Montageabschnitt (33) zu verbinden, und **dadurch gekennzeichnet, dass**
mindestens entweder der Montageabschnitt (33) oder der Verbindungsabschnitt (36) einen spannungsabsorbierenden Abschnitt aufweist, um eine Spannung zu absorbieren, die durch das Objekt (200) erzeugt wird, wobei
der spannungsabsorbierende Abschnitt eine Härte aufweist, die niedriger als jene des Schaltkreissubstrats (10) ist.

2. Gehäuse nach Anspruch 1, wobei:
der Verbindungsabschnitt (36) von dem Befestigungsabschnitt (31) ungefähr senkrecht zu dem Befestigungsabschnitt (31) gebogen ist; und
der Montageabschnitt (33) von dem Verbindungsabschnitt (36) weg ungefähr senkrecht zu dem Verbindungsabschnitt (36) gebogen ist.

3. Gehäuse nach einem der Ansprüche 1 oder 2, das weiterhin Folgendes aufweist:
eine Verstärkungsrippe (300), die an dem Verbindungsabschnitt (36) angeordnet ist und sich in einer Richtung erstreckt, welche den Befestigungsabschnitt (31) und den Montageabschnitt (33) verbindet.

4. Gehäuse nach einem der Ansprüche 1 bis 3, wobei:
der Montageabschnitt (33) einen ersten Schlitz (301) aufweist, der sich in einer Richtung erstreckt, die eine Kante des Montageabschnitts (33) und den Verbindungsabschnitt (36) verbindet.

5. Gehäuse nach einem der Ansprüche 1 bis 4, wobei:
der Verbindungsabschnitt (36) einen zweiten Schlitz (302, 302a) aufweist, der sich in einer Richtung erstreckt, die den Befestigungsabschnitt (31) und den Montageabschnitt (33) verbindet.

6. Gehäuse nach Anspruch 5, wobei:
der zweite Schlitz (302a) in einer Längsrichtung des Verbindungsabschnitts (36) zumindest an einem Ende des Verbindungsabschnitts (36) vorgesehen ist.

7. Gehäuse nach einem der Ansprüche 1 bis 6, wobei:
der Montageabschnitt (33) aus einem Material hergestellt ist, das plastisch verformbar ist, wenn der Montageabschnitt (33) an dem Objekt (200) durch eine Schraube (400) befestigt ist.

8. Gehäuse nach einem der Ansprüche 1 bis 7, wobei:
das Basisteil (30) aus Aluminium hergestellt ist, das eine 0,2 %-Dehngrenze aufweist, die gleich oder niedriger als 100 N/mm² ist.

9. Gehäuse nach einem der Ansprüche 1 bis 8, wobei:
das Basisteil (30) aus einem gepressten Aluminiumbrett hergestellt ist, das eine thermische Leitfähigkeit gleich oder größer als 150 W/m.K aufweist.

10. Gehäuse nach einem der Ansprüche 1 bis 9, wobei:
der Montageabschnitt (33) ein Basisdurchgangsloch (34) mit einem eingepressten Kragen (34a) aufweist, in welches eine Schraube (400) eingeschraubt ist.

11. Gehäuse nach Anspruch 10, wobei:
der Kragen (34a) aus Metall hergestellt ist.

12. Gehäuse nach einem der Ansprüche 10 oder 11, wobei:
der Kragen (34a) aus einem Aluminiumdruckgussprodukt hergestellt ist.

13. Gehäuse nach einem der Ansprüche 10 bis 12, wobei:
der Kragen (34a) so vorgesehen ist, dass er von dem Montageabschnitt (33) niedergedrückt wird.

14. Gehäuse nach einem der Ansprüche 10 bis 12, wobei:
der Kragen (34a) mindestens eine Endfläche aufweist, die ungefähr auf derselben Fläche wie jene des Montageabschnitts (33) positioniert ist; und
die Flächen des Kragens (34a) und des Montageabschnitts (33) eine Fläche des Objekts (200) berühren.

15. Gehäuse nach einem der Ansprüche 10 bis 14, wobei:
das Abdeckteil (20) einen Abdeckmontageabschnitt (21a) aufweist, der ein Abdeckdurchgangsloch (21a1) umfasst, in welches die Schraube (400) eingeschraubt ist;
das Abdeckdurchgangsloch (21a1) des Abdeckmontageabschnitts (21a) an einer Position vorgesehen ist, welche dem Basisdurchgangsloch (34) in dem Basismontageabschnitt (33) entspricht; und
das Abdeckteil (20) und das Basisteil (30) gemeinsam an dem Objekt (200) mittels der Schraube (400) durch das Abdeckdurchgangsloch (21a1) und das Basisdurchgangsloch (34) befestigt sind.

16. Gehäuse nach einem der Ansprüche 1 bis 15, das weiterhin Folgendes aufweist:
einen Dichtabschnitt (40), der zwischen dem Basisteil (30) und dem Schaltkreissubstrat (10) angeordnet ist.

17. Gehäuse nach einem der Ansprüche 1 bis 16, das weiterhin Folgendes aufweist:
einen Wärmeleiter (50), der zwischen dem Basisteil (30) und dem Schaltkreissubstrat (10) so angeordnet ist, dass er Wärme, die in dem Schaltkreissubstrat (10) erzeugt wird, durch das Basisteil (30) nach außen überträgt.

18. Gehäuse nach Anspruch 5, wobei:
der erste Schlitz (301) so vorgesehen ist, dass er sich kontinuierlich von dem in dem Verbindungsabschnitt (36) gebildeten zweiten Schlitz (302) weg erstreckt.

## Revendications

1. Boîtier pour contenir une unité électronique comprenant un substrat de circuit (10) et des composants électroniques (12) disposés sur le substrat de circuit (10), le boîtier comprenant :
un élément de base (30) et un élément de couverture (20), entre lesquels le substrat de circuit (10) est disposé, dans lequel
l'élément de base (30) comprend :
une partie de fixation (31), sur laquelle le substrat de circuit (10) est fixé ;
une partie de montage de base (33) devant être disposée sur un objet (200) ; et
une partie de raccordement (36), entre la partie de fixation (31) et la partie de montage (33), pour raccorder la partie de fixation (31) et la partie de montage (33), et
**caractérisée en ce que**
au moins l'une de la partie de montage (33) et de la partie de raccordement (36) comporte une partie d'absorption de contrainte pour absorber une contrainte générée par l'objet (200), dans lequel la partie d'absorption de contrainte a une dureté inférieure à celle du substrat de circuit (10).

2. Boîtier selon la revendication 1, dans lequel :
la partie de raccordement (36) est courbée depuis la partie de fixation (31) approximativement perpendiculairement à la partie de fixation (31) ; et
la partie de montage (33) est courbée depuis la partie de raccordement (36) approximativement perpendiculairement à la partie de raccordement (36).

3. Boîtier selon l'une quelconque des revendications 1 ou 2, comprenant également :
une nervure de renforcement (300) disposée sur la partie de raccordement (36) et s'étendant dans une direction reliant la partie de fixation (31) et la partie de montage (33).

4. Boîtier selon l'une quelconque des revendications 1 à 3, dans lequel :
la partie de montage (33) comprend une première fente (301) s'étendant dans une direction reliant un bord de la partie de montage (33) et de la partie de raccordement (36).

5. Boîtier selon l'une quelconque des revendications 1 à 4, dans lequel :
la partie de raccordement (36) comporte une seconde fente (302, 302a) s'étendant dans une direction reliant la partie de fixation (31) et la partie de montage (33).

6. Boîtier selon la revendication 5, dans lequel :
la seconde fente (302a) est disposée au moins à une extrémité de la partie de raccordement (36) dans une direction longitudinale de la partie de raccordement (36).

7. Boîtier selon l'une quelconque des revendications 1 à 6, dans lequel :
la partie de montage (33) est constituée d'un matériau déformable plastiquement quand la partie de montage (33) est fixée à l'objet (200) par une vis (400).

8. Boîtier selon l'une quelconque des revendications 1 à 7, dans lequel :
l'élément de base (30) est constitué d'aluminium ayant une limite d'élasticité à 0,2 % inférieure ou égale à 100 N/mm².

9. Boîtier selon l'une quelconque des revendications 1 à 8, dans lequel :
l'élément de base (30) est constitué d'une plaque d'aluminium pressée ayant une conductivité thermique supérieure ou égale à 150 W/m·K.

10. Boîtier selon l'une quelconque des revendications 1 à 9, dans lequel :
la partie de montage (33) comporte un trou (34) traversant la base muni d'une bague (34a) ajustée avec serrage dans lequel une vis (400) est vissée.

11. Boîtier selon la revendication 10, dans lequel :
la bague (34a) est constituée de métal.

12. Boîtier selon la revendication 10 ou 11, dans lequel :
la bague (34a) est constituée d'un matériau coulé en alliage d'aluminium.

13. Boîtier selon l'une quelconque des revendications 10 à 12, dans lequel :
la bague (34a) est agencée pour être enfoncée depuis la partie de montage (33).

14. Boîtier selon l'une quelconque des revendications 10 à 12, dans lequel :
la bague (34a) comporte au moins une face d'extrémité positionnée approximativement sur la même face que celle de la partie de montage (33) ; et
les faces de la bague (34a) et de la partie de montage (33) sont en contact avec une face de l'objet (200).

15. Boîtier selon l'une quelconque des revendications 10 à 14, dans lequel :
l'élément de couverture (20) comprend une partie de montage de couverture (21a) ayant un trou traversant de couverture (21a1) dans lequel la vis (400) est vissée ;
le trou traversant de couverture (21a1) de la partie de montage de couverture (21a) est disposé dans une position correspondant au trou (34) traversant la base dans la partie de montage de base (33) ; et
l'élément de couverture (20) et l'élément de base (30) sont fixés ensemble à l'objet (200) par la vis (400) à travers le trou traversant de couverture (21a1) et le trou (34) traversant la base.

16. Boîtier selon l'une quelconque des revendications 1 à 15, comprenant également :
une partie d'étanchéité (40) disposée entre l'élément de base (30) et le substrat de circuit (10).

17. Boîtier selon l'une quelconque des revendications 1 à 16, comprenant également :
un conducteur de chaleur (50) disposé entre l'élément de base (30) et le substrat de circuit (10) de façon à transmettre la chaleur générée dans le substrat de circuit (10) à l'extérieur à travers l'élément de base (30).

18. Boîtier selon la revendication 5, dans lequel :
la première fente (301) est agencée pour être étendue en continu depuis la seconde fente (302) formée dans la partie de raccordement (36).
